# EUROPEAN PATENT SPECIFICATION

(11) **EP 3 254 307 B1**
(45) Date of publication and mention of the grant of the patent: **02.03.2022**
(21) Application number: 16746928.7
(22) Date of filing: 06.01.2016
(51) Int. Cl.: H02N 13/00, C23C 14/50, H01L 21/67, H01L 21/683, H01L 21/687

(54) **RADIALLY OUTWARD PAD DESIGN FOR ELECTROSTATIC CHUCK SURFACE**
RADIALER ÄUSSERER KISSENENTWURF FÜR EINE ELEKTROSTATISCHE EINSPANNVORRICHTUNGSOBERFLÄCHE
CONCEPTION DE TAMPON RADIALEMENT EXTÉRIEUR POUR SURFACE DE MANDRIN ÉLECTROSTATIQUE

(30) Priority: 06.02.2015 US 201514616647
(43) Date of publication of application: 13.12.2017
(73) Proprietor: Applied Materials, Inc., Santa Clara, CA 95054 (US)
(72) Inventor: RAJ, Govinda, Bangalore 560040 (IN); HIRAHARA, Robert T., San Jose, California 95112 (US)
(74) Representative: Zimmermann & Partner Patentanwälte mbB
(86) International application number: PCT/US2016/012362
(87) International publication number: WO 2016/126360

(56) References cited:
- EP-A1- 1 852 907
- EP-A2- 0 806 793
- WO-A1-2014/149182
- US-A1- 2002 036 373
- US-A1- 2002 036 373
- US-A1- 2009 002 913
- US-A1- 2009 284 894
- US-A1- 2013 120 897

## Description

### FIELD

Embodiments disclosed herein generally relate to electrostatic chucks; more specifically, embodiments disclosed herein generally relate to a pattern for an electrostatic chuck surface.

### BACKGROUND

Electrostatic chucks are widely used to hold substrates, such as semiconductor substrates, during substrate processing in processing chambers used for various applications, such as physical vapor deposition (PVD), etching, or chemical vapor deposition. Electrostatic chucks typically include one or more electrodes embedded within a unitary chuck body, which comprises a dielectric or semi-conductive ceramic material across which an electrostatic clamping field can be generated. Semi-conductive ceramic materials, such as aluminum nitride, boron nitride, or aluminum oxide doped with a metal oxide, for example, may be used to enable Johnsen-Rahbek or non-Coulombic electrostatic clamping fields to be generated.

For example, document WO 2014/149182 A1 describes a substrate support assembly comprising an electrostatic chuck having an electrode embedded therein and having an aperture disposed therethrough, a conductive liner disposed on the surface of the electrostatic chuck within the aperture, a conductive tubing extending from a lower surface of the electrostatic chuck and axially aligned with the aperture, and a conductive coating at least partially within the aperture and at least partially within the conductive tubing, wherein the conductive coating provides a conductive path between the conductive liner and the conductive tubing.

Variability of the chucking force applied across the surface of a substrate during processing can cause an undesired deformation of the substrate, and can cause the generation and deposition of particles on the interface between the substrate and the electrostatic chuck. These particles can interfere with operation of the electrostatic chuck by affecting the amounts of chucking force. When the substrates are subsequently moved to and from the electrostatic chuck, these deposited particles can also scratch or gouge the substrates and ultimately lead to breakage of the substrate as well as wear away the surface of the electrostatic chuck.

Additionally, conventional electrostatic chucks may experience a sudden spike in temperature as a backside gas is introduced during deposition processes. Non-uniform or excessive heat transfer between a substrate and the electrostatic chuck can also cause damage to the substrate and/or chuck. For example, an over chucked substrate may result in an excessively large area of contact or an excessively concentrated area of contact between the substrate and chuck surfaces. Heat transfer occurring at the area of contact may exceed physical limitations of the substrate and/or chuck, resulting in cracks or breakage, and possibly generating and depositing particles on the chuck surface that may cause further damage or wear.

Thus, there is a need for a better electrostatic chuck which reduces damage to the substrate and/or chuck.

### SUMMARY

An electrostatic chuck assembly and processing chamber having the same are disclosed herein. In one embodiment, an electrostatic chuck assembly is provided that includes a body having an outer edge connecting a frontside surface and a backside surface. The body has chucking electrodes disposed therein. A wafer spacing mask is formed on the frontside surface of the body. The wafer spacing mask has a plurality of elongated features. The elongated features have long axes that are radial aligned from the center to the outer edge. The wafer spacing mask has a plurality of radially aligned gas passages defined between the elongated features.

In another embodiment, a processing chamber is provided that includes an electrostatic chuck assembly disposed in a processing volume of the processing chamber. The electrostatic chuck assembly includes a body having an outer edge connecting a frontside surface and a backside surface. The body has chucking electrodes disposed therein. A wafer spacing mask is formed on the frontside surface of the body. The wafer spacing mask has a plurality of elongated features. The elongated features have long axes that are radial aligned from the center to the outer edge. The wafer spacing mask has a plurality of radially aligned gas passages defined between the elongated features.

### BRIEF DESCRIPTION OF THE DRAWINGS

So that the manner in which the above recited features of the present invention can be understood in detail, a more particular description of the invention, briefly summarized above, may be had by reference to embodiments, some of which are illustrated in the appended drawings. It is to be noted, however, that the appended drawings illustrate only typical embodiments of this invention and are therefore not to be considered limiting of its scope, for the invention may admit to other equally effective embodiments.
Figure 1 is a schematic sectional side view of a physical vapor deposition (PVD) chamber within which an exemplary electrostatic chuck may be operated.
Figure 2 is a schematic cross-sectional detail view of electrostatic chuck assembly shown in Figure 1.
Figure 3 is a schematic cross-sectional detail view of a wafer spacing mask on a frontside surface of an electrostatic chuck assembly.
Figure 4 illustrates a top view of a top surface of the electrostatic chuck assembly, having an arrangement of minimum contact area features.

To facilitate understanding, identical reference numerals have been used, where possible, to designate identical elements that are common to the figures. It is contemplated that elements and features of one embodiment may be beneficially incorporated in other embodiments without further recitation.

### DETAILED DESCRIPTION

As described above the application of a non-uniform chucking force across a substrate, as well as an uneven or excessive heat transfer between the substrate and the chuck, can cause particle generation to occur at the substrate-chuck interface, which can result in damage or increased wear to the substrate and chuck. Therefore, reducing particle generation at the interface of an electrostatic chuck and a substrate may directly lead to reduced wear and the longer operational life of both elements, and may provide a more consistent and desired operation of the chuck.

Particle generation may be reduced by adjusting several design or process parameters. For example, the chuck surface may be designed to reduce or minimize the deformation of a chucked substrate, thereby reducing the probability of generating particles due to deformation of the substrate. In accordance with other physical design parameters (e.g., heat transfer gas flow), the chuck surface may employ particular arrangement(s) of contact points with the substrates, and/or may use particular material(s) having desired properties.

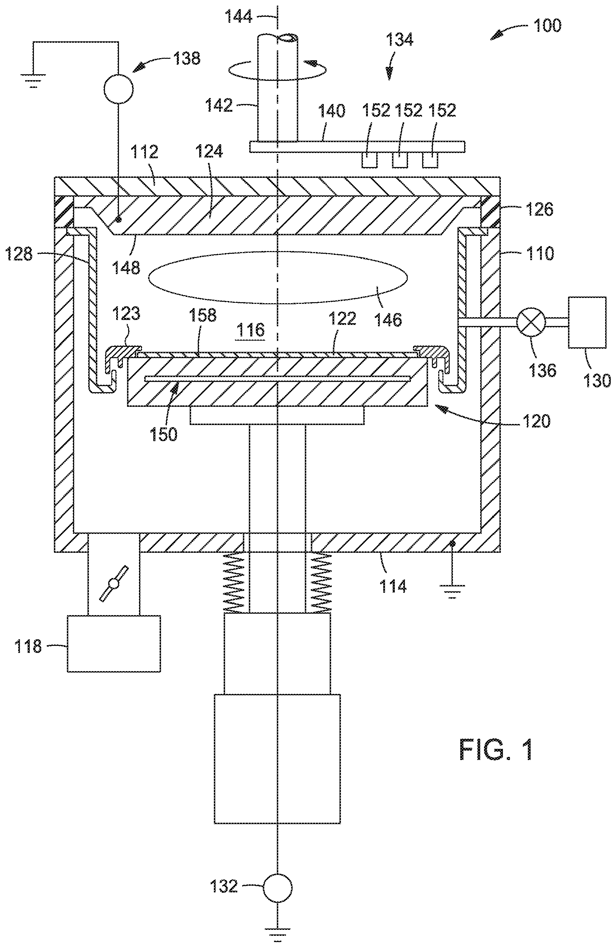

Figure 1 illustrates a schematic sectional side view of a PVD chamber 100 within which an exemplary an electrostatic chuck assembly 120 may be operated, according to one embodiment. The PVD chamber 100 includes chamber walls 110, a chamber lid 112, and a chamber bottom 114 defining a processing volume 116. The processing volume 116 may be maintained in a vacuum during processing by a pumping system 118. The chamber walls 110, chamber lid 112 and the chamber bottom 114 may be formed from conductive materials, such as aluminum and/or stainless steel. A dielectric isolator 126 may be disposed between the chamber lid 112 and the chamber walls 110, and may provide electrical isolation between the chamber walls 110 and the chamber lid 112. The chamber walls 110 and the chamber bottom 114 may be electrically grounded during operation.

The electrostatic chuck assembly 120 is disposed in the processing volume 116 for supporting a substrate 122 along a contact surface 158. The electrostatic chuck assembly 120 may move vertically within the processing volume 116 to facilitate substrate processing and substrate transfer. A chucking power source 132 may be coupled to the electrostatic chuck assembly 120 for securing the substrate 122 on the electrostatic chuck assembly 120, and may provide DC power or RF power to one or more chucking electrodes 150. The chucking electrodes 150 may have any suitable shape, such as semicircles, "D"-shaped plates, disks, rings, wedges, strips, and so forth. The chucking electrodes 150 may be made of any suitable electrically conductive material, such as a metal or metal alloy, for example.

A target 124 may be mounted on the chamber lid 112 and faces the electrostatic chuck assembly 120. The target 124 includes materials to be deposited on the substrate 122 during processing. A target power source 138 may be coupled to the target 124, and may provide DC power or RF power to the target to generate a negative voltage or bias to the target 124 during operation, or to drive plasma 146 in the chamber 100. The target power source 138 may be a pulsed power source. The target power source 138 may provide power to the target 124 up to about 10 kW, and at a frequency within a range of about 0.5 MHz to about 60 MHz, or more preferably between about 2 MHz and about 13.56 MHz. A lower frequency may be used to drive the bias (thereby controlling the ion energy), and a higher frequency may be used to drive the plasma. In one embodiment, the target 124 may be formed from one or more conductive materials for forming dielectric material by reactive sputtering. In one embodiment, the target 124 may include a metal or an alloy.

A shield assembly 128 may be disposed within the processing volume 116. The shield assembly 128 surrounds the target 124 and the substrate 122 disposed over the electrostatic chuck assembly 120 to retain processing chemistry within the chamber and to protect inner surfaces of chamber walls 110, chamber bottom 114 and other chamber components. In one embodiment, the shield assembly 128 may be electrically grounded during operation.

To allow better control of the materials deposted onto the substrate 122, a cover ring 123 may be positioned about the perimeter of the substrate 122 and rest on a portion of the shield assembly 128 during processing. The cover ring 123 may generally be positioned or moved within chamber 100 as the electrostatic chuck assembly 120 moves vertically. The cover ring 123 may be shaped to promote deposition near the edge of the substrate while preventing edge defects. The cover ring 123 may prevent deposition material from forming in and around the bottom of the processing chamber 100, for instance on the chamber bottom 114.

A process gas source 130 is fluidly connected to the processing volume 116 to provide one or more processing gases. A flow controller 136 may be coupled between the process gas source 130 and the processing volume 116 to control gas flow delivered to the processing volume 116.

A magnetron 134 may be disposed externally over the chamber lid 112. The magnetron 134 includes a plurality of magnets 152. The magnets 152 produce a magnetic field within the processing volume 116 near a front face 148 of the target 124 to generate a plasma 146 so that a significant flux of ions strike the target 124 causing sputter emission of the target material. The magnets 152 may rotate or linearly scan the target to increase uniformity of the magnetic field across the front face 148 of the target 124. As shown, the plurality of magnets 152 may be mounted on a frame 140 connected to a shaft 142. The shaft 142 may be axially aligned with a central axis 144 of the electrostatic chuck assembly 120 so that the magnets 152 rotate about the central axis 144.

The physical vapor deposition chamber 100 may be used to deposit a film onto substrate 122. Figure 1 schematically illustrates the physical vapor deposition chamber 100 in a processing configuration to deposit a film onto substrate 122. During deposition, a gas mixture including one or more reactive gases and one or more inert gases may be delivered to the processing volume 116 from the gas source 130. The plasma 146 formed near the front face 148 of the target 124 may include ions of the one or more inert gases and the one or more reactive gases. The ions in the plasma 146 strike the front face 148 of the target 124 sputtering the conductive material, which then reacts with the reactive gases to form a film onto the substrate 122.

Depending on the material to be formed on the substrate 122, the target 124 may be formed from a metal, such as aluminum, tantalum, hafnium, titanium, copper, niobium, or an alloy thereof. The reactive gases may include an oxidizing agent, a nitriding agent, or other reactive gases. According to one embodiment, the reactive gases may include oxygen for forming a metal oxide, or nitrogen for forming a metal nitride. The inert gases may include argon.

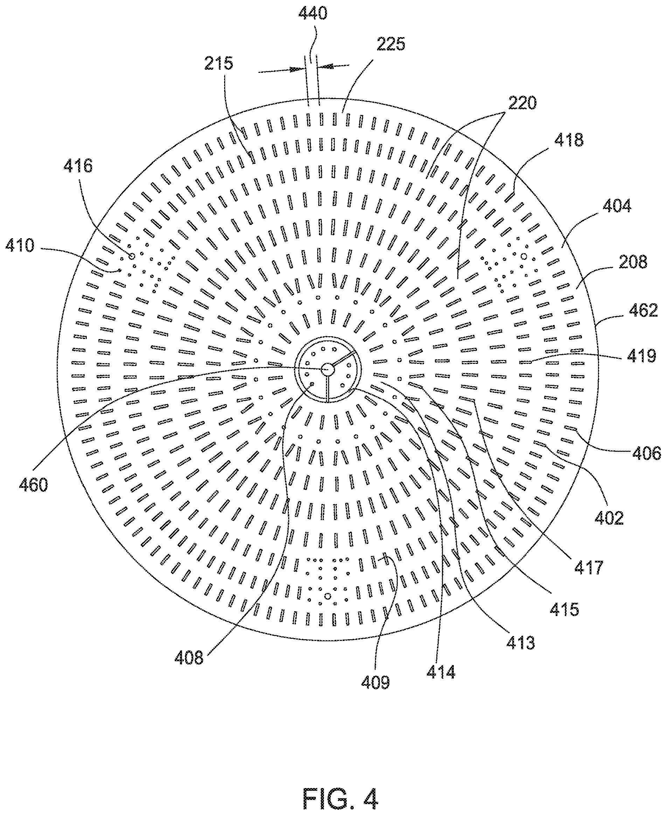

While PVD chamber 100 was described above with respect to the operation of an exemplary electrostatic chuck assembly to treat a substrate 122, note that a PVD chamber having the same or a similar configuration may also be used to deposit materials to produce a desired surface on the electrostatic chuck assembly120. For example, the PVD chamber 100 may use a mask to produce the electrostatic chuck surface shown in Figure 4.

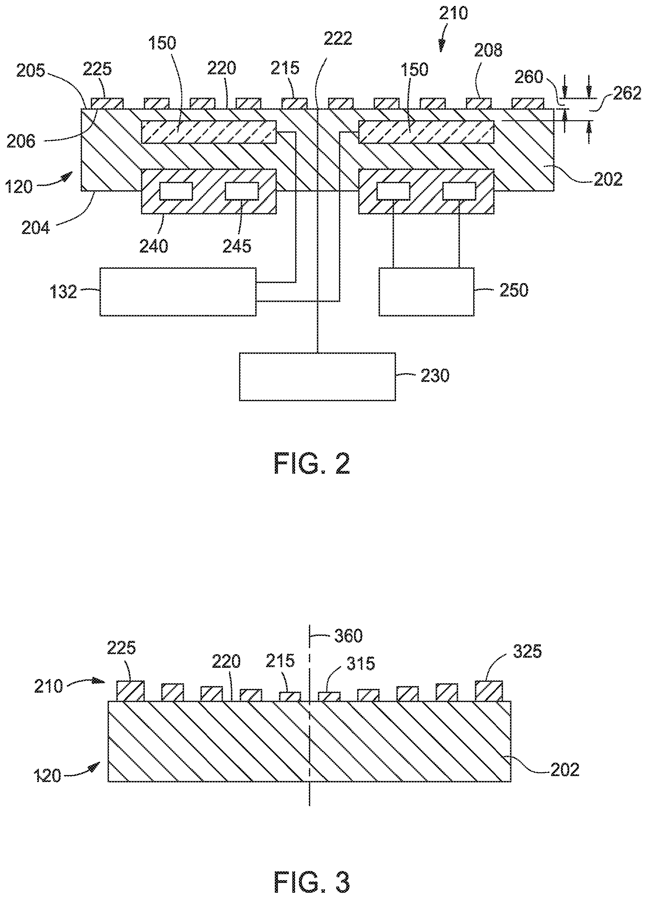

Figure 2 illustrates a schematic cross-sectional detail view of the electrostatic chuck assembly 120 shown in Figure 1. As shown, two chucking electrodes 150 are embedded into a body 202 the electrostatic chuck assembly 120. The body 202 may be fabricated from a dielectric material, such as a ceramic such as aluminum nitride and the like. The body 202 alternatively may be fabricated from plastic materials, such as from sheets of polyimide, polyether ether ketone, and the like. The body 202 has a backside surface 204 and a frontside surface 205. The frontside surface 205 is utilized to support the substrate 122.

A wafer spacing mask 210 is formed on the frontside surface 205 to minimize the contact area between the substrate 122 and the electrostatic chuck assembly 120. The wafer spacing mask 210 may be integrally formed from the material comprising the body 202, or may be comprised of one or more separate layers of material deposited on the frontside surface 205 of the body 202.

The wafer spacing mask 210 may have a top surface 208 and a bottom surface 206. The bottom surface 206 may be disposed directly upon the frontside surface 205 of the electrostatic chuck assembly 120. A thickness 260 of the wafer spacing mask 210 may be preferentially selected and spatially distributed across the frontside surface 205 to form features such as a plurality of mesas 215 and, optionally, an outer peripheral ring 225. The mesas 215 are generally configured to support the substrate 122 along the top surface 208 during processing. Gas passages 220 are formed between the mesas 215, allowing backside gas to be provided between the substrate 122 and the frontside surface 205 of the electrostatic chuck assembly 120. The outer peripheral ring 225 may be a solid ring or segments in a structure similar to the mesas 215 on the top surface 208 of the electrostatic chuck assembly 120, and utilized to confine or regulate the presence of the flow of backside gas from under the substrate 122 through the gas passages 220. In one embodiment, the outer peripheral ring 225 is similar to the mesas 215 in shape and configuration. Alternately, the outer peripheral ring 225 may be utilized to center the substrate 122 on the electrostatic chuck assembly 120.

A heat transfer gas source 230 is coupled through the electrostatic chuck assembly 120 to the frontside surface 205 to provide backside gas to the gas passages 220 defined between the mesas 215. The heat transfer gas source 230 provides a heat transfer gas (i.e., the backside gas) that flows between the backside of the substrate 122 and the electrostatic chuck assembly 120 in order to help regulate the rate of heat transfer between the electrostatic chuck assembly 120 and the substrate 122. The heat transfer gas may flow from outwards from a center of the electrostatic chuck assembly 120 and through the gas passages 220 around the mesas 215 and over the outer peripheral ring 225 into the processing volume 116 (shown in Figure 1). In one example, the heat transfer gas may comprise an inert gas, such as argon, helium, nitrogen, or a process gas. The heat transfer gas, such as argon, may be a process gas, and wherein a flow rate into the chamber volume is measured to obtain predictable results. The heat transfer gas may be delivered to the gas passages 220 through one or more inlets 222 in the electrostatic chuck assembly 120 that are in fluid communication with one or more gas passages 220 and the heat transfer gas source 230. The outer peripheral ring 225 contacts the substrate near its edge and may be preferentially designed to control the amount of heat transfer gas that escapes from between the substrate 122 and the electrostatic chuck assembly 120 into the processing volume. For example, the outer peripheral ring 225 and mesas 215 may be configured to provide a resistance to flow the transfer gas such that a pressure of the gas present between the substrate 122 and electrostatic chuck assembly 120 does not exceed a predetermined value.

Temperature regulation of the body 202, and ultimately the substrate 122, may further be monitored and controlled using one or more cooling channels 245 disposed in a cooling plate 240 disposed in contact with the backside surface 204 of the body 202. The cooling channels 245 are coupled to and in fluid communication with a fluid source 250 that provides a coolant fluid, such as water, though any other suitable coolant fluid, whether gas or liquid, may be used.

The wafer spacing mask 210 may be formed by depositing material through a mask onto the frontside surface 205. The use of a mask may allow better control of the size, shape, and distribution of features in the wafer spacing mask 210, thereby controlling the both the contact area of the mesas 215 and the conductance of the gas passages 220 defined between the mesas 215.

While depicted as having a flat top surface 208, each individual mesa 215 may generally have any suitable shape and height, each of which may be preferentially selected to fulfill particular design parameters (such as a desired chucking force and/or heat transfer). In one embodiment, the top surface 208 of the mesas 215 of the wafer spacing mask 210 may form a planar surface. In other embodiments, the top surface 208 of the mesas 215 of the wafer spacing mask 210 may form a non-planar surface, for example, a concave or convex surface. Generally, mesas 215 may have a mesa height 262 of about 1 micron to about 100 microns, or more preferably between about 1 micron and 30 microns. In one embodiment, the surface of the mesas 215 that supports the substrate 122 may have a small rounded bump-like shape to minimize total contact area between the mesas 215 and the substrate 122. In another embodiment, mesas 215 may include a small bump or protrusion atop a generally flat surface. In yet another embodiment, the frontside surface 205 itself may vary between relative high and low points (similar to mesas 215 and gas passages 220), and wafer spacing mask 210 may be formed on this non-uniform surface.

In one or more embodiments, a non-uniform mask profile may be used to form the wafer spacing mask 210. Generally, the non-uniform mask profile may permit the height of each mesa 215 or depth of each gas passage 220 to be controlled individually or in combination. A wafer spacing mask 210 created using the non-uniform mask profile may advantageously provide a more uniform chucking force across a substrate.

Figure 3 illustrates a schematic cross-sectional detail view of a wafer spacing mask deposited onto an electrostatic chuck assembly, according to one embodiment. In this example, the height of mesas 215 increase with lateral distance from a centerline 360 of the electrostatic chuck assembly 120, so that a maximum mesa height occurs at the outermost mesa 325, corresponding to outer peripheral ring 225. Likewise, the heights of the mesas 215 may be at a minimum at mesas 315 most proximate the centerline 360. As described above, individual mesas 215 may have any suitable shape and the mask profile may be selected to provide mesas 215 having different sizes and/or shapes. The mask profile may provide for lateral symmetry so that corresponding mesas 215 at a particular lateral distance from centerline 360 have the same height and/or shape.

Figure 4 illustrates a top view of the frontside surface 205 of the electrostatic chuck assembly 120. The frontside surface 205 of the electrostatic chuck assembly 120 has the wafer spacing mask 210 of deposited thereon. Thus, the frontside surface 205 of the electrostatic chuck assembly 120 can be characterized as having raised areas 402 defined by the wafer spacing mask 210 and unmodified areas 404 defined by the portions of the frontside surface 205 substantially uncovered by the wafer spacing mask 210. The unmodified areas 404 of the frontside surface 205 may include a layer of the same materials deposited to form the wafer spacing mask 210 which remains below the top surface 208 of the mesas 215 and defines the gas passages 220.

The wafer spacing mask 210 may also include elongated features 406 that correspond to the mesas 215 of Figure 2. The wafer spacing mask 210 may also include cylindrical features 408, and 410, and center tap features 414. The top surface 208 may also have lift pin hole openings 416. The cylindrical features 410 may be formed inward of the lift pin hole openings 416 in place of an elongated feature to locally reduce the substrate contact area and allow more gas flow to compensate for thermal non-uniformities caused by presence of the lift pin hole openings 416 extending through the body 202 of the electrostatic chuck assembly 120. The long axis of the elongated features 406 of the wafer spacing mask 210 may generally be radially aligned from a centerline 460 to an outer edge 462 of the electrostatic chuck assembly 120. Additionally, the rounded features 408, and 410 may also be radially aligned the elongated features 406 from the centerline 460 to the outer edge 462. An outermost ring 418 of mesas 215 may define the outer peripheral ring 225. Gas passages 220 are defined between the top surfaces 208 of the mesas 215 defining the wafer spacing mask 210. The gas passages 220 may also radially aligned from the centerline 460 to the outer edge 462 of the electrostatic chuck assembly 120, or may also extend in different directions, such as concentrically from the centerline 460 of the electrostatic chuck assembly 120.

The elongated features 406 may be arranged in concentric rows 409 emanating from the center. In one embodiment, each concentric row 409 has the same number of elongated features 406. In another embodiment, the number of elongated features 406 in each of the concentric rows 409 may increase from the centerline 460 to the outer edge 462. For example, the number of elongated features 406 in the row 409 nearest the outer edge 462 is greater than the number of elongated features 406 in the concentric row 409 nearest the centerline 460. In yet another embodiment, the number of elongated features 406 may double in one or more subsequent concentric row 409. For example, the number of elongated features 406 in a first row 413 may be half of the number of elongated features 406 in a second row 415. The number of elongated features 406 in the second row 415 may be half of number of elongated features 406 in a fourth row 417. The number of elongated features 406 in the fourth row 417 may be half of number of elongated features 406 in a sixth row 419. That is, the number of elongated features 406 may double in every other row 409 starting from the centerline 460 to the outer edge 462. In this manner, a spacing 440 between elongated features 406 in the rows 409 remains fairly consistent. The spacing 440 between adjacent elongated features 406 in a row 409 may have a lateral distance of about 0.1 inches to about 0.5 inches. The radial length of long axis of the elongated feature 406 may be within a range of about 0.1 inches to about 0.5 inches. The spacing between radially aligned elongated features 406 in adjacent rows 409 may be within a range of about 0.1 inches to about 0.5 inches.

To provide further reduce particle generation and wear of the top surface 208 of the electrostatic chuck assembly 120, the material composition of the wafer spacing mask 210 may be preferentially selected based on several properties. For example, the material composition for an improved top surface 208 may be selected to exhibit one or more of high hardness, a high modulus of elasticity, low coefficient of friction, and/or a low wear factor. In one embodiment, the wafer spacing mask 210 may be fabricated from titanium nitride. In another embodiment, the wafer spacing mask 210 may be fabricated from diamond-like carbon (DLC) compositions, such as DYLYN^{™} (a trademark of Sulzer Ltd.) and the like.

The radial aligned gas passages 220 and mesas 215 reduce the pressure of the backside gas flowing through the gas passages 220. The radial aligned gas passages 220 and mesas 215 promote the flow of the backside gas by reducing the conductance of the gas flow. For example, the radial aligned gas passages 220 and mesas 215 may reduce the backside gas pressure at the outer edge 462 from non-radial aligned gas passages and mesas from about 50% to about 70%, such as about 64% at less than 10 SCCM flow rates on a 300 mm electrostatic chuck assembly 120 as compared to conventional electrostatic chuck assemblies not having radially aligned elongated features. Thus, where the backside gas having a pressure of about 3 Torr and 3 SCCM at the inlet, such as inlet 222, and a pressure of about 7 Torr on the outer edge of a conventional ESC, having non-radial aligned mesas, may have the pressure reduced to about 4 Torr on the ESC 120 having radial aligned gas passages 220 and mesas 215. The reduced pressure beneficially increases the velocity of the backside gas by about 100%. Similarly, where the backside gas having a pressure of about 3 Torr and 0.1 SCCM at an inlet, such as inlet 222, and a pressure of about 4 Torr on the outer edge of a conventional ESC, having non-radial aligned mesas, may be able to reduce the pressure to about 2 Torr on the ESC 120 having radial aligned gas passages 220 and mesas 215. The reduced pressure beneficially increases the velocity of the backside gas by about 100%. The improved backside gas pressure and velocity promotes thermal uniformity of the substrate 122 disposed on the wafer spacing mask 210. Since the backside gas flows more freely, the backside gas is better able to regulate the temperature of the substrate 122 as heat is be transferred from the substrate 122 more readily. For example, sudden temperature spikes from deposition when the backside gas is introduced and the heat transfer from the electrostatic chuck assembly 120 to the substrate 122 upon process termination is reduced by the freely flowing backside gas which does not further promote rapid heating of the substrate 122. Additionally, the improved backside gas pressure and velocity negates the need to tune the flow of the backside gas to promote thermal uniformity. In one embodiment, the radial aligned gas passages 220 and mesas 215 produce a backside gas pressure between about 2.5 Torr and about 8 Torr, such as 2.5 Torr, at the outer edge 462 when flowing about 0.1 SCCM of backside gas through the inlet 222 at a pressure of about 3 Torr. In another embodiment, the radial aligned gas passages 220 and mesas 215 produce a backside gas pressure of about 4 Torr at the outer edge 462 when flowing about 3 SCCM of backside gas through the inlet 222 at a pressure of about 3 Torr.

The maximum velocity of the backside gas at the outer edge 462 is between about 6 mm/s and about 1 mm/s, such as about 5.77 mm/s when flowing about 3 SCCM of backside gas through the inlet 222 into the gas passages 220. In one embodiment, the maximum velocity is 4 mm/s when a rate of 3 SCCM of backside gas is flowed into the inlet 222 at 3 Torr. In another embodiment, the maximum velocity is 1.31 mm/s when a rate of 21 SCCM of backside gas is flowed into the inlet 222 at 3 Torr. The maximum velocity of the backside gas at the outer edge 462 is between about 6 mm/s and about 1 mm/s, such as about 4 mm/s when flowing about 0.1 SCCM to about 1 SCCM of backside gas through the inlet 222 into the gas passages 220. In one embodiment, the maximum velocity is 2.1 mm/s when a rate of 0.1 SCCM of backside gas is flowed into the inlet 222 at 3 Torr. In another embodiment, the maximum velocity is 4.7 mm/s when a rate of 0.1 SCCM of backside gas is flowed into the inlet 222 at 3 Torr.

The total area of top surface 208 of the wafer spacing mask 210 that is in contact with the substrate 122 is about 20 cm² to about 60 cm², which is an increase in surface contact area of nearly three times greater than conventional wafer spacing masks. The increased contact area of the radial aligned mesas 215 increases the theoretical chucking force on the substrate from about 800 grams to about 3300 grams for the same chucking voltage. The addition contact area of the radial aligned gas passages 220 and mesas 215 with the substrate 122 reduce the overall stress on the substrate 122 significantly while the actual surface area of the electrostatic chuck assembly 120 in contact with substrate 122 is only between about 3% to about 15%. The radial aligned mesas 215 reduce the friction between the substrates 122 and the electrostatic chuck assembly 120. The radial aligned mesas 215 reduce wear and particle generation due to greater surface contact between the substrate 122 and the electrostatic chuck assembly 120. The greater contact area between the electrostatic chuck assembly 120 and the substrate 122 provides additional support to the substrate and thus lowers the overall stress across the substrate 122 from chucking the substrate 122. For example, the electrostatic chuck assembly 120, having radial aligned mesas 215, may reduce the stress about 30% on the substrate 122 over a conventional electrostatic chuck assembly. Furthermore, the radial aligned mesas 215 reduce the temperature gradient from the centerline 460 to outer edge 462 of the substrate 122 as compared to a conventional electrostatic chuck assembly. The substrate 122, especially along the outside perimeter, experiences a reduction in the stress, from the increased contact area, and temperature gradient, from the decrease pressure and increase velocity of the backside gas, which may damage (i.e., crack) the substrate. The stress on the substrate 122 is dependent on not only the thermal gradient but also the material. For example, a TTN film on the substrate 122 may be about 58 MPa at a time corresponding to the greatest temperature gradient in the film and then reach less than about 8 MPa after about 10 seconds. Similarly, a DLC film on the substrate 122 may be about 50 MPa at a time corresponding to the greatest temperature gradient in the film and then reach less than about 11 MPa after about 10 seconds. Where the substrate 122 stress is maximum at a time step of about 0 seconds to about 1 second due to a maximum difference in the temperature at the initial time step. The fatigue stress on the substrate during 0 to 3 seconds is very critical , which will result in fracture of the material in contact, hence preheating the substrate and controlled landing of the substrate on the Electrostatic chuck are both very critical . Convective heating of the substrate by increasing the inlet temperature is a possibility during the substrate transport in to the change. The blades of the heater can also be actively maintained at elevated temperature based on the process recipe +/- 50 degree C to reduce the thermal shock and thermal transient fatigue stress on initial 3 second contact.

Advantageously, the radially outward design of the mesas 215 and gas passages 220 on the frontside surface 205 of the electrostatic chuck assembly 120 improves thermal uniformity on substrates processed thereon. The radially outward design of the mesas 215 and gas passages 220 provide better control of backside gas for the electrostatic chuck assembly 120. The radially outward design of the mesas 215 and gas passages 220 promote reduced wear characteristics due to more surface area contact between the substrate 122 and the electrostatic chuck assembly 120. The radially outward design of the mesas 215 and gas passages 220 on the top surface 208 of the electrostatic chuck assembly 120 provides improved support to substrate backside due to improved contact area for reducing the stress, and subsequent damage, to the substrate 122. Thus, the disclosed embodiments of the present invention provide a pattern of features for an electrostatic chuck assembly that are directed toward providing reduced particle generation and reduced wear of substrates and chucking devices.

In addition to the examples described above, some additional nonlimiting examples may be described as follows.
Example 1. An electrostatic chuck assembly, comprising:
   a body having chucking electrodes disposed therein, the body having an outer edge connecting a frontside surface and a backside surface; and
   a wafer spacing mask formed on the frontside surface, the wafer spacing mask having a plurality of elongated features, the elongated features having long axes that are radial aligned from the center to the outer edge, the wafer spacing mask having a plurality of radially aligned gas passages defined between the elongated features, wherein the radial aligned gas passages and mesas are arranged to maintain a pressure less than about 3 Torr at the outer edge when flowing about 3 SCCM of backside gas through the gas passages.
Example 2. An electrostatic chuck assembly, comprising:
   a body having chucking electrodes disposed therein, the body having an outer edge connecting a frontside surface and a backside surface; and
   a wafer spacing mask formed on the frontside surface, the wafer spacing mask having a plurality of elongated features, the elongated features having long axes that are radial aligned from the center to the outer edge, the wafer spacing mask having a plurality of radially aligned gas passages defined between the elongated features, wherein a velocity of backside gas into the radial aligned gas passages is about 7 mm/s or less at the outer edge when flowing about 3 SCCM of backside gas through the gas passages.
Example 3. An electrostatic chuck assembly, comprising:
   a body having chucking electrodes disposed therein, the body having an outer edge connecting a frontside surface and a backside surface; and
   a wafer spacing mask formed on the frontside surface, the wafer spacing mask having a plurality of elongated features, the elongated features having long axes that are radial aligned from the center to the outer edge, the wafer spacing mask having a plurality of radially aligned gas passages defined between the elongated features, wherein a velocity of backside gas into the radial aligned gas passages is about 4 mm/s or less at the outer edge when flowing at least 0.1 SCCM of backside gas through the gas passages.
Example 4. An electrostatic chuck assembly, comprising:
   a body having chucking electrodes disposed therein, the body having an outer edge connecting a frontside surface and a backside surface; and
   a wafer spacing mask formed on the frontside surface, the wafer spacing mask having a plurality of elongated features, the elongated features having long axes that are radial aligned from the center to the outer edge, the wafer spacing mask having a plurality of radially aligned gas passages defined between the elongated features, wherein the radial aligned gas passages and mesas are arranged to maintain a pressure less than about 1 to 4 Torr at the outer edge when flowing at least 0.1 SCCM of backside gas through the gas passages.
Example 5. An electrostatic chuck assembly, comprising:
   a body having chucking electrodes disposed therein, the body having an outer edge connecting a frontside surface and a backside surface; and
   a wafer spacing mask formed on the frontside surface, the wafer spacing mask having a plurality of elongated features, the elongated features having long axes that are radial aligned from the center to the outer edge, the wafer spacing mask having a plurality of radially aligned gas passages defined between the elongated features, wherein a velocity of backside gas into the radial aligned gas passages is about 1.31 mm/s or less at the outer edge when flowing about 3 SCCM of backside gas through the gas passages.
Example 6. An electrostatic chuck assembly, comprising:
   a body having chucking electrodes disposed therein, the body having an outer edge connecting a frontside surface and a backside surface; and
   a wafer spacing mask formed on the frontside surface, the wafer spacing mask having a plurality of elongated features, the elongated features having long axes that are radial aligned from the center to the outer edge, the wafer spacing mask having a plurality of radially aligned gas passages defined between the elongated features, wherein a velocity of backside gas into the radial aligned gas passages is about 2 mm/s to about 5 mm/s or less at the outer edge when flowing at least 0.1 SCCM of backside gas through the gas passages.

While the foregoing is directed to embodiments of the invention, other and further embodiments of the invention may be devised without departing from the basic scope thereof. The invention is defined by the appended claims.

## Claims

1. An electrostatic chuck assembly (120), comprising:
a body (202) having chucking electrodes (150) disposed therein, the body having an outer edge (462) connecting a frontside surface (205) and a backside surface (204); and
a wafer spacing mask (210) formed on the frontside surface (205), the wafer spacing mask having a plurality of mesas (215), the mesas comprising elongated features (406) having long axes, the elongated features being arranged in concentric rows (409) emanating from a center, wherein the long axes of the elongated features in each concentric row (409) are radially aligned from the center to the outer edge (462), the wafer spacing mask (210) having a plurality of radially aligned gas passages (220) defined between the elongated features (406); and
wherein at least one round feature (408) is radially aligned with at least two of the elongated features (406).

2. The electrostatic chuck assembly (120) of claim 1, wherein a number of elongated features (406) arranged in a row of concentric rows nearest the outer edge is greater than a number of elongated features (406) arranged in a row of concentric rows nearest the center.

3. The electrostatic chuck assembly (120) of claim 1, wherein a number of elongated features in an adjacent pair of rows (409) doubles.

4. The electrostatic chuck assembly (120) of claim 1, wherein the radial aligned gas passages (220) and mesas (215) are arranged to maintain a pressure less than about 5 Torr at the outer edge when flowing at least 0.1 SCCM of backside gas through the gas passages.

5. The electrostatic chuck assembly (120) of claim 1, wherein the radial aligned gas passages (220) and mesas (215) are arranged to maintain a pressure less than about 4 Torr to about 7 Torr at the outer edge when flowing at least 3 SCCM of backside gas through the gas passages.

6. A plasma processing chamber (100), comprising:
a lid (112), walls and a bottom defining an processing volume (116); and
an electrostatic chuck assembly (120) according to any of claims 1 or 5 disposed in the processing volume.

7. The plasma processing chamber (100) of claim 6 or the electrostatic chuck assembly (120) of claim 1, wherein wafer spacing mask (210) comprises:
at least one round feature (408).

8. The plasma processing chamber (100) of claim 6, wherein a number of elongated features (406) arranged in a row of concentric rows (409) nearest the outer edge is greater than a number of elongated features (406) arranged in a row of concentric rows (409) nearest the center.

9. The plasma processing chamber (100) of claim 6, wherein a number of elongated features (406) in an adjacent pair of rows doubles.

10. The plasma processing chamber (100) of claim 6 or the electrostatic chuck assembly (120) of claim 1, wherein the radial aligned elongated features (406) have a substrate contact area of between 3% and 15%.

11. The plasma processing chamber (100) of claim 6, wherein a velocity of backside gas into the radial aligned gas passages (220) is about 4 mm/s or less at the outer edge (462) when flowing at least 0.1 to about 3 SCCM of backside gas through the gas passages.

## Patentansprüche

1. Elektrostatische Spannvorrichtungsbaugruppe (120), umfassend:
einen Körper (202), der darin angeordnete Spannelektroden (150) aufweist, wobei der Körper eine Außenkante (462) aufweist, die eine Vorderseitenoberfläche (205) und eine Rückseitenoberfläche (204) verbindet; und
eine Waferabstandsmaske (210), die auf der Vorderseitenoberfläche (205) ausgebildet ist, wobei die Waferabstandsmaske eine Vielzahl von erhöhten Ebenen (215) aufweist, wobei die erhöhten Ebenen längliche Merkmale (406) umfassen, die lange Achsen aufweisen, wobei die länglichen Merkmale in konzentrischen Reihen (409) angeordnet sind, die von einer Mitte ausgehen, wobei die langen Achsen der länglichen Merkmale in jeder konzentrischen Reihe (409) radial von der Mitte zur Außenkante (462) ausgerichtet sind, wobei die Waferabstandsmaske (210) eine Vielzahl von radial ausgerichteten Gasdurchgängen (220) aufweist, die zwischen den länglichen Merkmalen (406) definiert sind; und
wobei mindestens ein rundes Merkmal (408) radial mit mindestens zwei der länglichen Merkmale (406) ausgerichtet ist.

2. Die elektrostatische Spannvorrichtungsbaugruppe (120) gemäß Anspruch 1, wobei eine Anzahl von länglichen Merkmalen (406), die in einer Reihe von konzentrischen Reihen angeordnet sind, die der Außenkante am nächsten ist, größer ist als eine Anzahl von länglichen Merkmalen (406), die in einer Reihe von konzentrischen Reihen angeordnet sind, die der Mitte am nächsten ist.

3. Die elektrostatische Spannvorrichtungsbaugruppe (120) gemäß Anspruch 1, wobei sich eine Anzahl von länglichen Merkmalen in einem angrenzenden Paar von Reihen (409) verdoppelt.

4. Die elektrostatische Spannvorrichtungsbaugruppe (120) gemäß Anspruch 1, wobei die radial ausgerichteten Gasdurchgänge (220) und erhöhten Ebenen (215) angeordnet sind, einen Druck von weniger als etwa 5 Torr an der Außenkante aufrechtzuerhalten, wenn mindestens 0,1 SCCM eines Rückseitengases durch die Gasdurchgänge strömt.

5. Die elektrostatische Spannvorrichtungsbaugruppe (120) gemäß Anspruch 1, wobei die radial ausgerichteten Gasdurchgänge (220) und erhöhten Ebenen (215) angeordnet sind, einen Druck von weniger als etwa 4 Torr bis etwa 7 Torr an der Außenkante aufrechtzuerhalten, wenn mindestens 3 SCCM eines Rückseitengases durch die Gasdurchgänge strömt.

6. Plasmaprozessierungskammer (100), umfassend:
einen Deckel (112), Wände und einen Boden, die ein Prozessierungsvolumen (116) definieren; und
eine elektrostatische Spannvorrichtungsbaugruppe (120) gemäß einem der Ansprüche 1 oder 5, die in dem Prozessierungsvolumen angeordnet ist.

7. Die Plasmaprozessierungskammer (100) gemäß Anspruch 6 oder die elektrostatische Spannvorrichtungsbaugruppe (120) gemäß Anspruch 1, wobei Waferabstandsmaske (210) umfasst:
mindestens ein rundes Merkmal (408).

8. Die Plasmaprozessierungskammer (100) gemäß Anspruch 6, wobei eine Anzahl von länglichen Merkmalen (406), die in einer Reihe von konzentrischen Reihen (409) angeordnet sind, die der Außenkante am nächsten ist, größer ist als eine Anzahl von länglichen Merkmalen (406), die in einer Reihe von konzentrischen Reihen (409) angeordnet sind, die der Mitte am nächsten ist.

9. Die Plasmaprozessierungskammer (100) gemäß Anspruch 6, wobei sich eine Anzahl von länglichen Merkmalen (406) in einem angrenzenden Paar von Reihen verdoppelt.

10. Die Plasmaprozessierungskammer (100) gemäß Anspruch 6 oder die elektrostatische Spannvorrichtungsbaugruppe (120) gemäß Anspruch 1, wobei die radial ausgerichteten länglichen Merkmale (406) eine Substratkontaktfläche zwischen 3 % und 15 % aufweisen.

11. Die Plasmaprozessierungskammer (100) gemäß Anspruch 6, wobei eine Geschwindigkeit eines Rückseitengases in die radial ausgerichteten Gasdurchgänge (220) etwa 4 mm/s oder weniger an der Außenkante (462) beträgt, wenn mindestens 0,1 bis etwa 3 SCCM des Rückseitengases durch die Gasdurchgänge strömt.

## Revendications

1. Assemblage de support électrostatique (120), comprenant :
un corps (202) ayant des électrodes de support (150) disposées en lui, le corps ayant un bord extérieur (462) reliant une surface avant (205) et une surface arrière (204) ; et
un masque d'espacement de tranche (210) formé sur la surface avant (205), le masque d'espacement de tranche ayant une pluralité de plateaux en forme de mesas (215), les plateaux en forme de mesas comprenant des caractéristiques allongées (406) ayant des axes longs, les caractéristiques allongées étant agencées en rangées concentriques (409) partant d'un centre, dans lequel les axes longs des caractéristiques allongées (406) dans chaque rangée concentrique (409) sont alignés radialement du centre jusqu'au bord extérieur (462), le masque d'espacement de tranche (210) ayant une pluralité de passages de gaz (220) alignés radialement définis entre les caractéristiques allongées (406) ; et
dans lequel au moins une caractéristique ronde (408) est alignée radialement avec au moins deux des caractéristiques allongées (406).

2. Assemblage de support électrostatique (120) selon la revendication 1, dans lequel un nombre de caractéristiques allongées (406) agencées dans une rangée de rangées concentriques plus proche du bord extérieur est plus grand qu'un nombre de caractéristiques allongées (406) agencées dans une rangée de rangées concentriques plus proche du bord intérieur.

3. Assemblage de support électrostatique (120) selon la revendication 1, dans lequel un nombre de caractéristiques allongées dans une paire de rangées (409) adjacentes double.

4. Assemblage de support électrostatique (120) selon la revendication 1, dans lequel les passages de gaz (220) et les plateaux en forme de mesas (215) alignés radiaux sont agencés pour maintenir une pression inférieure à environ 5 Torr au bord extérieur lors de l'écoulement à au moins 0,1 cm³/min de gaz côté arrière à travers les passages de gaz.

5. Assemblage de support électrostatique (120) selon la revendication 1, dans lequel les passages de gaz (220) et les plateaux en forme de mesas (215) alignés radiaux sont agencés pour maintenir une pression inférieure à environ 4 Torr à 7 Torr au bord extérieur lors de l'écoulement à au moins 3 cm³/min de gaz côté arrière à travers les passages de gaz.

6. Chambre de traitement par plasma (100) comprenant :
un couvercle (112), des parois et un fond définissant un volume de traitement (116) ; et
un assemblage de support électrostatique (120) selon l'une quelconque des revendications 1 ou 5 disposé dans le volume de traitement.

7. Chambre de traitement par plasma (100) selon la revendication 6 ou assemblage de support électrostatique (120) selon la revendication 1, dans lequel un masque d'espacement de tranche (210) comprend :
au moins une caractéristique ronde (408).

8. Chambre de traitement par plasma (100) selon la revendication 6, dans lequel un nombre de caractéristiques allongées (406) agencées dans une rangée de rangées (409) concentriques plus proche du bord extérieur est plus grand qu'un nombre de caractéristiques allongées (406) agencées dans une rangée de rangées concentriques (409) plus proche du bord intérieur.

9. Chambre de traitement par plasma (100) selon la revendication 6, dans lequel un nombre de caractéristiques allongées dans une paire de rangées adjacentes double.

10. Chambre de traitement par plasma (100) selon la revendication 6 ou assemblage de support électrostatique (120) selon la revendication 1, dans lequel les caractéristiques allongées (406) alignées radiales ont une aire de contact de substrat entre 3 % et 15 %.

11. Chambre de traitement par plasma (100) selon la revendication 6, dans lequel une vitesse de gaz côté arrière arrivant dans les passages de gaz (220) alignés radiaux est d'environ 4 mm/s ou moins au bord extérieur (462) lors de l'écoulement à au moins 0,1 à 3 cm³/min de gaz côté arrière à travers les passages de gaz.
